# EUROPÄISCHE PATENTSCHRIFT

(11) **EP 1 411 364 B1**
(45) Veröffentlichungstag und Bekanntmachung des Hinweises auf die Patenterteilung: **11.03.2009**
(21) Anmeldenummer: 03019885.7
(22) Anmeldetag: 02.09.2003
(51) Int. Cl.: G01R 31/36

(54) **Fahrzeugbordnetz mit Batteriezustandserkennung am Pluspol der Batterie**
Vehicle instrument panel for identifying the state of a battery connected to the positive pole of the battery
Tableau de bord d'un véhicule pour identifier l'état de batterie connectée au pôle positif de la batterie

(30) Priorität: 18.10.2002 DE 10248679
(43) Veröffentlichungstag der Anmeldung: 21.04.2004
(73) Patentinhaber: ROBERT BOSCH GMBH, 70442 Stuttgart (DE)
(72) Erfinder: Lutz, Oliver, 73669 Lichtenwald (DE); Rieger, Reinhard, 74336 Brackenheim (DE); Kneifel, Marcus, 71701 Schwieberdingen (DE); Fink, Holger, 70565 Stuttgart (DE)

(56) Entgegenhaltungen:
- US-A- 5 747 189
- US-B1- 6 300 763
- US-B1- 6 424 157

## Beschreibung

Die Erfindung betrifft ein Fahrzeugbordnetz mit Batteriezustandserkennung am Pluspol der Batterie.

### Stand der Technik

Aus der DE 100 01 340 A1 ist ein Verfahren zur Messfehlerkompensation bei der Stromerfassung an einem Energiespeicher bekannt. Bei diesem bekannten Verfahren erfolgt die Stromerfassung unter Verwendung zweier Stromwandler, die an der vom Pluspol der Batterie zu einem Generator und den Verbrauchern führenden Leitung angeordnet sind. Die Stromwandler liefern ihr jeweiliges Ausgangssignal an eine eine Korrekturstufe aufweisende Auswerteelektronik. Am Ausgang der Auswerteelektronik werden korrigierte Messwerte zur Verfügung gestellt, die dem Batteriestrom entsprechen.

Weiterhin sind bereits Vorsicherungsboxen bekannt, die an den Pluspol einer Fahrzeugbatterie angeschlossen sind und zur Energieverteilung und Absicherung von Leitungen und Verbrauchern im Fahrzeugbordnetz dienen. Als Komponenten beinhaltet eine derartige im Fahrzeug vorgesehene Vorscherungsbox schraub- oder steckbare Schmelzsicherungen.

Weiterhin sind bereits Steuergeräte zum Energiemanagement bekannt, welche zwischen dem Minuspol der Batterie eines Kraftfahrzeugs und Masse angeordnet sind. Dabei wird der Batteriestrom im Bereich des Minuspols der Batterie erfasst. Bei dieser Vorgehensweise ist eine Verbindung notwendig, die von der Batterie zum Steuergerät führt, und eine weitere Verbindung, die vom Steuergerät auf Fahrzeugmasse führt.

Weiterhin sind aus der Zeitschrift AutoTechnology 4/2001, Seiten 82 - 85, in Modulform vorgesehene Energieversorgungssysteme für ein Kraftfahrzeug bekannt. Bei diesen Energieversorgungssystemen vorgesehene Module enthalten Relais, Sicherungen und elektronische Komponenten, die den Stromfluss im elektrischen Versorgungsnetz steuern. Zu diesen Modulen gehören beispielsweise Vorsicherungsboxen, die die Hauptzweige des Energienetzes absichern, sowie Sicherungs- und Relaisboxen, welche untergeordnete Netze schützen und Lasten oder Gruppen von Lasten zu- und abschalten.

Aus der US-A-5747189 ist bereits ein Fahrzeugbordnetz bekannt, welches eine Batterie aufweist und zur Versorgung einer Vielzahl von Verbrauchern wie beispielsweise Licht, elektrischer Schalter oder Mikroprozessoren vorgesehen ist. Weiterhin ist hierbei eine Batteriezustandserkennung und eine Steuereinheit zum Energiemanagement vorgesehen, über welche die Verbraucher mit Energie versorgt werden.

### Vorteile der Erfindung

Ein Fahrzeugbordnetz mit den im Anspruch 1 angegebenen Merkmalen weist demgegenüber mehrere Vorteile auf. Das Modul gemäß der Erfindung bildet einen zentralen, intelligenten elektrischen Energiekoordinator eines Fahrzeugs. Über dieses Modul erfolgt die Versorgung der Verbraucher des Bordnetzes. Aufgrund des direkten Anschlusses an den Pluspol der Fahrzeugbatterie kann das Modul in vorteilhafter Weise zur Batteriezustandserkennung verwendet werden, da dort die zur Batteriezustandserkennung notwendigen Größen zur Verfügung stehen. Der Minuspol der Batterie kann direkt mit Masse verbunden werden, da das bei bekannten Lösungen zwischen dem Minuspol der Batterie und Masse vorgesehene Steuergerät entfällt. Dies bedeutet einen Kostenvorteil und ist in elektrischer Hinsicht vorteilhaft, da der Widerstand in der Masseleitung zwischen dem Minuspol der Batterie und Fahrzeugmasse nicht durch zusätzliche Überbrückungswiderstände, die bei einer Einbindung eines Steuergeräts in die genannte Verbindung entstehen, erhöht wird.

Vorzugsweise sind zwischen dem Pluspol der Batterie und den zu den Verbrauchern führenden Versorgungsleitungen innerhalb des Moduls Sicherungen vorgesehen, deren Zustand überwacht bzw. detektiert wird und von der Steuereinheit zum elektrischen Energiemanagement berücksichtigt wird. Diese steht weiterhin mit den Mitteln zur Batteriezustandserkennung in Verbindung, um auch den Zustand der Batterie bei der Verteilung der Energie im Kraftfahrzeug berücksichtigen zu können.

In vorteilhafter Weise steht die Steuereinheit zum elektrischen Energiemanagement über Busverbindungen mit weiteren Steuergeräten des Kraftfahrzeugs und mit Verbrauchern zwecks eines Datenaustausches in Verbindung. Auf diese Weise können auch die weiteren Steuergeräte und Verbraucher in das elektrische Energiemanagement einbezogen werden.

Mittels der Steuereinheit zum elektrischen Energiemanagement können auch zu bestimmten Verbrauchern führende Leitungen oder zu Verbrauchergruppen führende Leitungen unter Verwendung eines ebenfalls innerhalb des Moduls angeordneten Leistungsschalters unterbrochen und geschlossen werden. Dies erlaubt es beispielsweise, eine Ruhestromabschaltung im Fehlerfall sowie eine Trennung eines gesamten Bordnetzbereiches im Servicefall, bei einem Fahrzeugtransport oder bei einer vorübergehenden Stilllegung des Fahrzeugs durchzuführen. Weiterhin kann im Falle eines Unfalls ein gesamter Bordnetzbereich von der Batterie getrennt werden. Dadurch ist sichergestellt, dass bei einem unfallbedingten Kurzschluss im Bordnetz kein Kabelbrand auftritt. Ferner können auch im Weg der zum Fahrzeuggenerator führenden Leitung und im Weg der zum Starter führenden Leitung innerhalb des Moduls Leistungsschalter bzw. Batterietrennschalter angeordnet sein. Folglich ist eine externe Montage derartiger Bauteile nicht mehr notwendig, was zu einer Einsparung von Kosten führt.

### Zeichnung

Nachfolgend werden Ausführungsbeispiele für die Erfindung anhand der Zeichnungen erläutert. Die Figur 1 zeigt ein Blockschaltbild eines ersten Ausführungsbeispiels für die Erfindung, die Figur 2 ein Blockschaltbild eines zweiten Ausführungsbeispiels für die Erfindung, die Figur 3 ein Blockschaltbild eines dritten Ausführungsbeispiels für die Erfindung, die Figur 4 ein Blockschaltbild eines vierten Ausführungsbeispiels für die Erfindung, die Figur 5 ein Blockschaltbild eines fünften Ausführungsbeispiels für die Erfindung, die Figur 6 ein Blockschaltbild eines sechsten Ausführungsbeispiels für die Erfindung und die Figur 7 ein Blockschaltbild eines siebten Ausführungsbeispiels für die Erfindung.

### Beschreibung

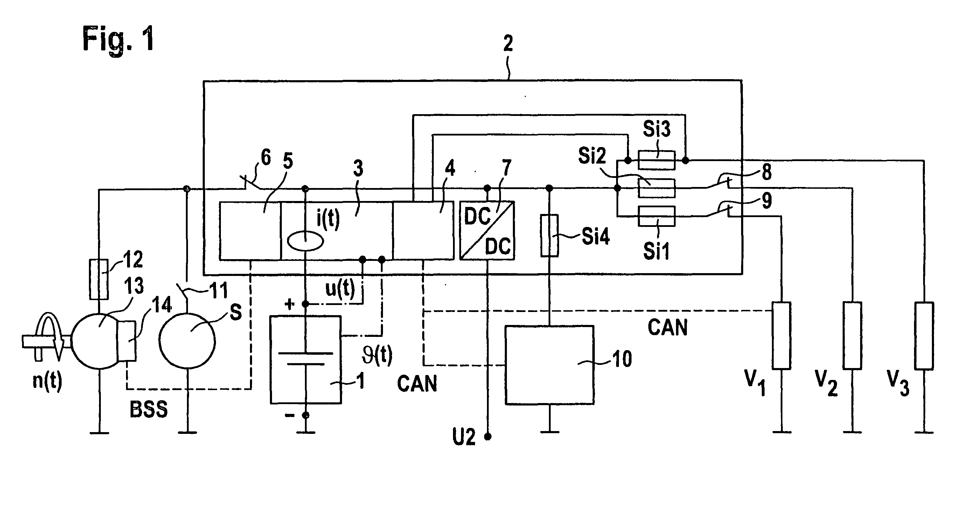

Die Figur 1 zeigt ein Blockschaltbild eines ersten Ausführungsbeispiels für die Erfindung. Das dargestellte Fahrzeugbordnetz enthält eine Batterie 1, welche einen Pluspol und einen Minuspol aufweist. Der Minuspol der Batterie ist mit Masse verbunden. Direkt an den Pluspol der Batterie 1 ist ein Modul 2 angeschlossen. Dieses Modul weist eine integrierte Elektronik auf, zu welcher Mittel 3 zur Batteriezustandserkennung, eine Steuereinheit 4 zum Energiemanagement des Fahrzeugbordnetzes, eine Einheit 5 zur Diagnose und Regelung eines Generators, ein Batterietrennschalter 6, ein Gleichspannungswandler 7 und Schmelzsicherungen Si1 - Si4 gehören.

Diese Schmelzsicherungen Si1 - Si4 sind mit jeweils einem Versorgungsausgang des Moduls 2 verbunden, wobei zwischen der Sicherung Si2 und dem zugehörigen Versorgungsausgang des Moduls 2 ein Leistungsschalter 8 und zwischen der Sicherung Si1 und dem zugehörigen Versorgungsausgang des Moduls 2 ein Leistungsschalter 9 vorgesehen ist. Der Batterietrennschalter 6 und die beiden Leistungsschalter 8 und 9 werden jeweils von der Steuereinheit 4 zum Energiemanagement angesteuert und im Betrieb des Fahrzeugs bei Bedarf geöffnet und geschlossen.

An die den Sicherungen Si1, Si2 und Si3 zugeordneten Versorgungsausgängen des Moduls 2 sind Verbraucher V₁, V₂ und V₃ angeschlossen. An den der Sicherung Si4 zugeordneten Ausgang ist ein weiterer Verbraucher 10 angeschlossen, bei dem es sich um eine elektrohydraulische Bremse oder ein elektrisches Lenkungssystem handeln kann.

Der von der Batterie 1 abgelegene Anschluss des Batterietrennschalters 6 ist mit einem weiteren Anschluss des Moduls 2 verbunden, an welchen über ein Starterrelais 11 der Starter S des Kraftfahrzeugs und über eine externe Sicherung 12 der Generator 13 des Kraftfahrzeugs angeschlossen ist. Der Generator 13 steht mit einem Regler 14 in Verbindung, der seinerseits über eine bitsynchronische Schnittstelle BSS mit der innerhalb des Moduls 2 vorgesehenen Einheit 5 zur Diagnose und Regelung des Generators kontaktiert ist.

Die Mittel 3 zur Batteriezustandserkennung enthalten einen Batteriestrommesser, einen Batteriespannungsmesser und einen Batterietemperaturmesser. Der Batteriestrommesser führt die Batteriestrommessung entweder unter Verwendung von Hall-Sensoren, einem oder mehreren Stromwandlern oder einem Stromshunt durch. Im Rahmen dieser Batteriestrommessung wird der gesamte Batteriestrom erfasst, d. h. sowohl der in die Batterie fließende Strom als auch der aus der Batterie fließende Strom. Die Messung der Batteriespannung u(t) und der Batterietemperatur δ(t) erfolgt unter Zuhilfenahme von externen Sensoren, welche Informationen über die Batteriespannung bzw. die Batterietemperatur zur Verfügung stellen. Aus dem gemessenen Batteriestrom, der gemessenen Batteriespannung und der gemessenen Batterietemperatur wird ein den Batteriezustand beschreibendes Signal ermittelt, welches der Steuereinheit 4 zum elektrischen Energiemanagement zur Verfügung gestellt wird. Als weitere Eingangssignale erhält die Steuereinheit 4 von einer oder mehreren der Schmelzsicherungen Si1, Si2, Si3 und Si4 abgeleitete Diagnosesignale, die den Zustand der jeweiligen Schmelzsicherung beschrieben.

Die Steuereinheit 4 führt in Abhängigkeit von den ihr zugeführten Zustandssignalen das elektrische Energiemanagement des Bordnetzes durch. Sie kann zu diesem Zweck beispielsweise den Zustand des Batterietrennschalters 6, des Leistungsschalters 8 und des Leistungsschalters 9 verändern. Erkennt die Steuereinheit 4 beispielsweise anhand der Batteriezustandssignale das Vorliegen einer schwachen Batterie, dann schaltet sie Verbraucher, deren Funktion für die Sicherheit des Kraftfahrzeugs nicht wesentlich sind, ab. Zu diesen für die Sicherheit des Kraftfahrzeugs nicht wesentlichen Verbrauchern gehört beispielsweise die Heckscheibenheizung.

Weiterhin kommuniziert die Steuereinheit 4 über einen Fahrzeugbus, beispielsweise einen CAN-Bus oder einen LIN-Bus, mit weiteren Steuergeräten des Fahrzeugs und/oder einzelnen Verbrauchern, beispielsweise dem Verbraucher V₁. Im Rahmen dieser Kommunikation kann die Steuereinheit 4 den anderen Komponenten Informationen über den Energiezustand des Fahrzeugsbordnetzes zukommen lassen, welche von der jeweiligen Komponenten in geeigneter Form umgesetzt werden, beispielsweise im Sinne einer Verringerung des dort anfallenden Energieverbrauchs.

Die Steuereinheit 4 steht auch mit der Einheit 5 zur Diagnose und Regelung des Generators 13 in Verbindung und kann deshalb auch Informationen über den Zustand des Generators beim elektrischen Energiemanagement berücksichtigen und auch eine Regelung des Generators in die Wege leiten, aufgrund welcher der Ladezustand der Batterie beim Vorliegen einer schwachen Batterie schnell wieder erhöht wird.

Mittels des Gleichspannungswandlers 7, der ebenfalls innerhalb des Moduls 2 angeordnet ist, wird die von der Batterie 1 abgeleitete Versorgungsspannung umgesetzt in eine andere Versorgungsspannung U2, die von weiteren, in der Figur 1 nicht dargestellten Verbrauchern benötigt wird.

Durch die vorstehend beschriebene Integration elektronischer Komponenten in das Modul 2, welches eine Vorsicherungsbox bildet, wird die Funktionalität bekannter Vorsicherungsboxen erweitert, was einen deutlichen Kundennutzen bedeutet. Die beschriebene Integration von Elektronik zur Batteriezustandserkennung und zum Energiemanagement in eine Vorsicherungsbox ist insbesondere deshalb von Vorteil, weil sich letztere in der Nähe der Batterie befindet und dort Zustandsgrößen wie der Batteriestrom, die Batteriespannung und die Batterietemperatur verfügbar sind. Des weiteren ist an dieser Stelle eine vom Energiemanagement ausgehende Kontrolle und Diagnose von Energieflusspfaden, Sicherungen, Leistungsschaltern, usw., vorteilhaft durchführbar.

Durch die Verwendung einer Vorsicherungsbox als Einbauort für die oben beschriebene Elektronik und für die weiteren oben genannten Komponenten entfällt die Notwendigkeit eines zusätzlichen, im Fahrzeug zu verbauenden Steuergerätes. Dies ist hinsichtlich Kosten und Bauraum ein großer Vorteil. Für die Hersteller von Kraftfahrzeugen besteht in weiterer Vorteil darin, dass sich die Anzahl der Steuergeräte im Fahrzeug nicht erhöht.

Die Erfindung wird auch der Tatsache gerecht, dass die Auswahl von elektrischen Verbrauchern in Kraftfahrzeugen stetig steigt. Dazu gehören auch sicherheitsrelevante Verbraucher wie eine elektrohydraulische Bremse oder eine elektrische Servolenkung. Durch die beschriebene Integration der Batteriezustandserkennung und des Energiemanagements in eine mit dem Pluspol der Batterie verbundene Vorsicherungsbox kann die Verfügbarkeit des Bordnetzes durch eine intelligente Zu- und Abschaltung von Verbrauchern und eine Steuerung der Lade- bzw. Entladestrategie der Batterie erhöht werden.

Mittels eines Batterietrennschalters, der innerhalb des Moduls bzw. der Vorsicherungsbox angeordnet ist, kann beispielsweise auch eine Starterleitung bei Fahrzeugen mit im Heck befindlicher Batterie abgesichert werden.

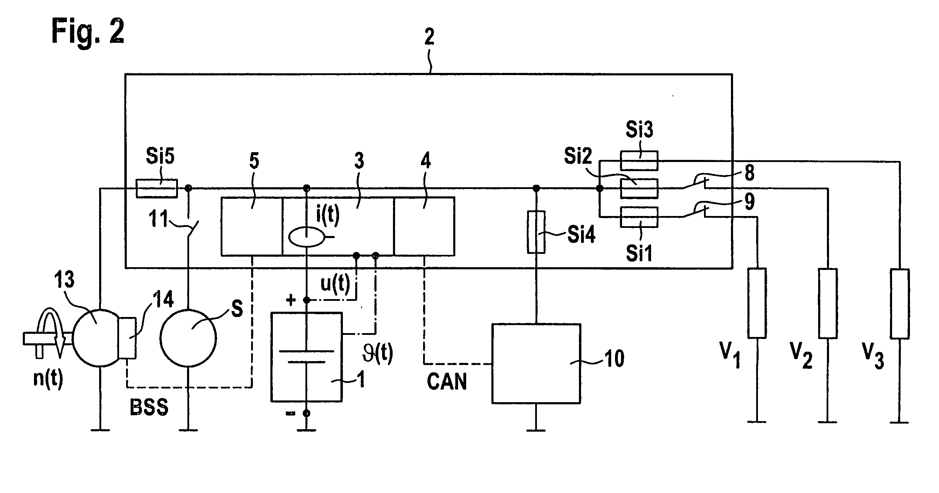

Die Figur 2 zeigt ein Blockschaltbild eines zweiten Ausführungsbeispiels für die Erfindung. Das in der Figur 2 dargestellte Fahrzeugbordnetz enthält eine Batterie 1, welche einen Pluspol und einen Minuspol aufweist. Der Minuspol der Batterie ist mit Masse verbunden. Direkt an den Pluspol der Batterie 1 ist ein Modul 2 angeschlossen. Dieses Modul weist eine integrierte Elektronik auf, zu welcher Mittel 3 zur Batteriezustandserkennung, eine Steuereinheit 4 zum Energiemanagement des Fahrzeugbordnetzes, eine Einheit 5 zur Diagnose und Regelung eines Generators, ein Starter-Relais 11 und Schmelzsicherungen Si1 - Si5 gehören.

Die Schmelzsicherungen Si1 - Si4 sind mit jeweils einem Versorgungsausgang des Moduls 2 verbunden, wobei zwischen der Sicherung Si2 und dem zugehörigen Versorgungsausgang des Moduls 2 ein Leistungsschalter 8 und zwischen der Sicherung Si1 und dem zugehörigen Versorgungsausgang des Moduls 2 ein Leistungsschalter 9 vorgesehen ist. Die beiden Leistungsschalter 8 und 9 sowie das Starter-Relais 11 werden jeweils von der Steuereinheit 4 zum Energiemanagement angesteuert und im Betrieb des Fahrzeugs bei Bedarf geöffnet und geschlossen.

An die den Sicherungen Si1, Si2 und Si3 zugeordneten Versorgungsausgängen des Moduls 2 sind Verbraucher V₁, V₂ und V₃ angeschlossen. An den der Sicherung Si4 zugeordneten Ausgang ist ein weiterer Verbraucher 10 angeschlossen, bei dem es sich um eine elektrohydraulische Bremse oder ein elektrisches Lenkungssystem handeln kann.

Der von der Batterie 1 abgelegene Anschluss der Sicherung Si5 ist mit einem weiteren Anschluss des Moduls 2 verbunden, an welchen der Generator 13 des Kraftfahrzeugs angeschlossen ist. Der Generator 13 steht mit einem Regler 14 in Verbindung, der seinerseits über eine bitsynchrone Schnittstelle BSS mit der innerhalb des Moduls 2 vorgesehenen Einheit 5 zur Diagnose und Regelung des Generators kontaktiert ist. Der von der Batterie 1 abgelegene Anschluss des Starter-Relais 11 ist mit dem Starter S verbunden, dessen anderer Anschluss an Masse liegt.

Die Mittel 3 zur Batteriezustandserkennung enthalten einen Batteriestrommesser, einen Batteriespannungsmesser und einen Batterietemperaturmesser. Der Batteriestrommesser führt die Batteriestrommessung entweder unter Verwendung von Hall-Sensoren, einem oder mehreren Stromwandlern oder einem Stromshunt durch. Im Rahmen dieser Batteriestrommessung wird der gesamte Batteriestrom erfasst, d. h. sowohl der in die Batterie fließende Strom als auch der aus der Batterie fließende Strom. Die Messung der Batteriespannung u(t) und der Batterietemperatur δ(t) erfolgt unter Zuhilfenahme von externen Sensoren, welche Informationen über die Batteriespannung bzw. die Batterietemperatur zur Verfügung stellen. Aus dem gemessenen Batteriestrom, der gemessenen Batteriespannung und der gemessenen Batterietemperatur wird ein den Batteriezustand beschreibendes Signal ermittelt, welches der Steuereinheit 4 zum elektrischen Energiemanagement zur Verfügung gestellt wird.

Die Steuereinheit 4 führt in Abhängigkeit von den ihr zugeführten Zustandssignalen das elektrische Energiemanagement des Bordnetzes durch. Sie kann zu diesem Zweck beispielsweise den Zustand des Starter-Relais 11, des Leistungsschalters 8 und des Leistungsschalters 9 verändern. Erkennt die Steuereinheit 4 beispielsweise anhand der Batteriezustandssignale das Vorliegen einer schwachen Batterie, dann schaltet sie Verbraucher, deren Funktion für die Sicherheit des Kraftfahrzeugs nicht wesentlich sind, ab. Zu diesen für die Sicherheit des Kraftfahrzeugs nicht wesentlichen Verbrauchern gehört beispielsweise die Heckscheibenheizung.

Weiterhin kommuniziert die Steuereinheit 4 über einen Fahrzeugbus, beispielsweise einen CAN-Bus, mit weiteren Steuergeräten des Fahrzeugs und/oder dem Verbraucher 10. Im Rahmen dieser Kommunikation kann die Steuereinheit 4 den anderen Komponenten Informationen über den Energiezustand des Fahrzeugsbordnetzes zukommen lassen, welche von der jeweiligen Komponenten in geeigneter Form umgesetzt werden, beispielsweise im Sinne einer Verringerung des dort anfallenden Energieverbrauchs.

Die Steuereinheit 4 steht auch mit der Einheit 5 zur Diagnose und Regelung des Generators 13 in Verbindung und kann deshalb auch Informationen über den Zustand des Generators beim elektrischen Energiemanagement berücksichtigen und auch eine Regelung des Generators in die Wege leiten, aufgrund welcher der Ladezustand der Batterie beim Vorliegen einer schwachen Batterie schnell wieder erhöht wird.

Bei dem in der Figur 2 gezeigten Ausführungsbeispiel, welches weitgehend dieselben Vorteile aufweist wie das in der Figur 1 gezeigte Ausführungsbeispiel, sind im Unterschied zur Figur 1 das Starter-Relais 11 und die zwischen der Batterie und dem Generator 13 vorgesehene Sicherung Si5 ebenfalls innerhalb des Moduls 2 angeordnet. Dadurch werden weitere Vorteile erzielt. Ein erster dieser weiteren Vorteile besteht in einer vereinfachten Ansteuerung des Starter-Relais 11. Ein weiterer Vorteil besteht darin, dass die Sicherung Si5 und das Starter-Relais 11 nicht als zusätzliche externe Komponenten verbaut werden müssen.

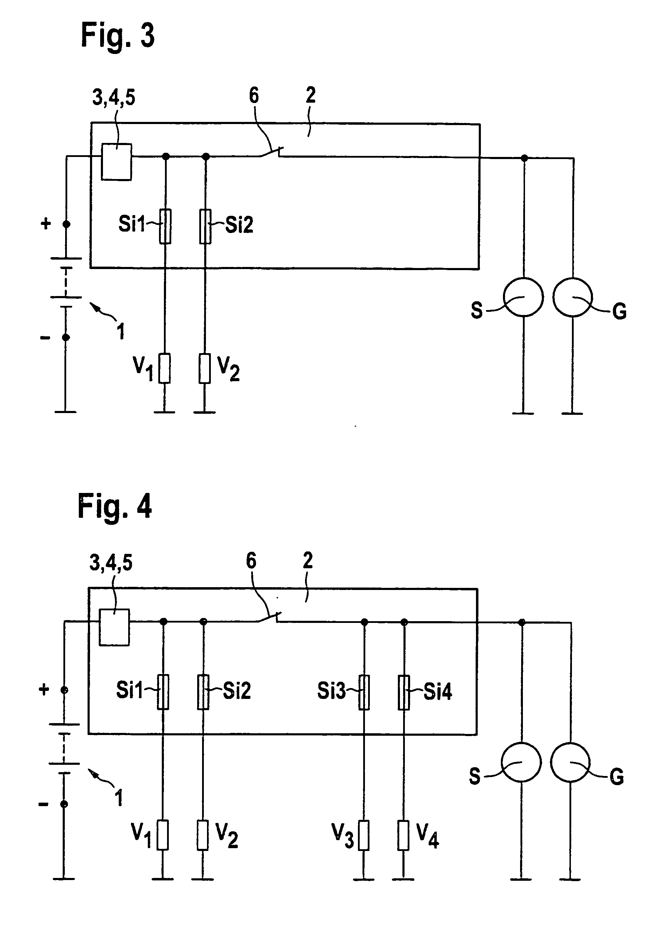

Die Figur 3 zeigt ein Blockschaltbild eines dritten Ausführungsbeispiels für die Erfindung. Das in der Figur 3 dargestellte Fahrzeugbordnetz enthält eine Batterie 1, welche einen Pluspol und einen Minuspol aufweist. Der Minuspol der Batterie ist mit Masse verbunden. Direkt an den Pluspol der Batterie 1 ist ein Modul 2 angeschlossen. Dieses Modul weist eine integrierte Elektronik auf, zu welcher Mittel 3 zur Batteriezustandserkennung, eine Steuereinheit 4 zum Energiemanagement des Fahrzeugbordnetzes, eine Einheit 5 zur Diagnose und Regelung eines Generators, ein Leistungsschalter 6 und Schmelzsicherungen Si1 und Si2 gehören.

Diese Schmelzsicherungen Si1 und Si2 sind mit jeweils einem Versorgungsausgang des Moduls 2 verbunden. Der Leistungsschalter 6 wird von der Steuereinheit 4 zum Energiemanagement angesteuert und im Betrieb des Fahrzeugs bei Bedarf geöffnet und geschlossen.

An die den Sicherungen Si1 und Si2 zugeordneten Versorgungsausgänge des Moduls 2 sind Verbraucher V₁ und V₂ angeschlossen.

Der von der Batterie 1 abgelegene Anschluss des Leistungsschalters 6 ist mit einem weiteren Anschluss des Moduls 2 verbunden, an welchen der Starter S des Kraftfahrzeugs und der Generator G des Kraftfahrzeugs angeschlossen sind.

Die Mittel 3 zur Batteriezustandserkennung, die Steuereinheit 4 zum elektrischen Energiemanagement und die Einheit 5 zur Diagnose und Regelung des Generators arbeiten ebenso wie es oben im Zusammenhang mit den Figuren 1 bzw. 2 beschrieben wurde.

Ein besonderes Merkmal dieses Ausführungsbeispiels besteht in der Integration des Leistungsschalters 6 in das Modul 2, bei welchem es sich um eine Vorsicherungsbox handelt. Der in der Figur 3 gezeigte Leistungsschalter kann beispielsweise im Falle eines Unfalls automatisch geöffnet werden, um bei einem Kurzschluss das Auftreten eines Kabelbrandes zu vermeiden.

Die Figur 4 zeigt ein Blockschaltbild eines vierten Ausführungsbeispiels für die Erfindung. Das in der Figur 4 dargestellte Fahrzeugbordnetz enthält eine Batterie 1, welche einen Pluspol und einen Minuspol aufweist. Der Minuspol der Batterie ist mit Masse verbunden. Direkt an den Pluspol der Batterie 1 ist ein Modul 2 angeschlossen. Dieses Modul weist eine integrierte Elektronik auf, zu welcher Mittel 3 zur Batteriezustandserkennung, eine Steuereinheit 4 zum Energiemanagement des Fahrzeugbordnetzes, eine Einheit 5 zur Diagnose und Regelung eines Generators, ein Leistungsschalter 6 und Schmelzsicherungen Si1 - Si4 gehören.

Die Schmelzsicherungen Si1 - Si4 sind mit jeweils einem Versorgungsausgang des Moduls 2 verbunden. Der Leistungsschalter 6 wird von der Steuereinheit 4 zum Energiemanagement angesteuert und im Betrieb des Fahrzeugs bei Bedarf geöffnet und geschlossen. Er ist zwischen den Sicherungen Si1, Si2 und Si3, Si4 in der Weise angeordnet, dass die Sicherungen Si1 und Si2 auch bei geöffnetem Leistungsschalter mit der Batterie verbunden sind, während die Sicherungen Si3 und S4 bei geöffnetem Leistungsschalter 6 von der Batterie abgetrennt sind.

An die den Sicherungen Si1 und Si2 zugeordneten Versorgungsausgänge des Moduls 2 sind Verbraucher V₁ und V₂ angeschlossen. An die den Sicherungen Si3 und Si4 zugeordneten Versorgungsausgänge des Moduls 2 sind Verbraucher V₃ und V₄ angeschlossen. Folglich sind bei geöffnetem Leistungsschalter 6 die Verbraucher V₃ und V₄ von der Batterie abgetrennt, während die Verbraucher V₁ und V₂ weiterhin mit Energie versorgt werden.

Der von der Batterie 1 abgelegene Anschluss des Leistungsschalters 6 ist weiterhin mit einem weiteren Anschluss des Moduls 2 verbunden, an welchen der Starter S des Kraftfahrzeugs und der Generator G des Kraftfahrzeugs angeschlossen sind.

Die Mittel 3 zur Batteriezustandserkennung, die Steuereinheit 4 zum elektrischen Energiemanagement und die Einheit 5 zur Diagnose und Regelung des Generators arbeiten ebenso wie es oben im Zusammenhang mit den Figuren 1 bzw. 2 beschrieben wurde.

Ein besonderes Merkmal dieses Ausführungsbeispiels besteht in der beschriebenen Integration des Leistungsschalters 6 in das Modul 2, bei welchem es sich um eine Vorsicherungsbox handelt. Der in der Figur 4 gezeigte Leistungsschalter kann beispielsweise im Falle eines Unfalls automatisch geöffnet werden, um bei einem Kurzschluss das Auftreten eines Kabelbrandes zu vermeiden. Weiterhin kann er auch im Fehler-, Transport- oder Servicefall zur Ruhestromabschaltung geöffnet werden.

Da er zwischen der Batterie und dem Starter und auch zwischen der Batterie und dem Generator angeordnet ist, führt er den Starterstrom und kann im Sinne einer Absicherung der ansonsten ungeschützten Starter-/Generatorleitung verwendet werden.

Durch die Anordnung der Sicherungen Si1 und Si2 vor dem Leistungsschalter 6 ist die Versorgung der Verbraucher V₁ und V₂ auch bei geöffnetem Leistungsschalter 6 sichergestellt, wobei es sich bei diesen Verbrauchern um Notverbraucher bzw. Komponenten handelt, die nicht von der Batterie getrennt werden dürfen.

Bei diesem Ausführungsbeispiel kann folglich eine Gruppe von Verbrauchern durch ein Öffnen des Leistungsschalters 6 von der Batterie 1 getrennt werden, während eine andere Gruppe von Verbrauchern weiterhin mit Energie versorgt wird.

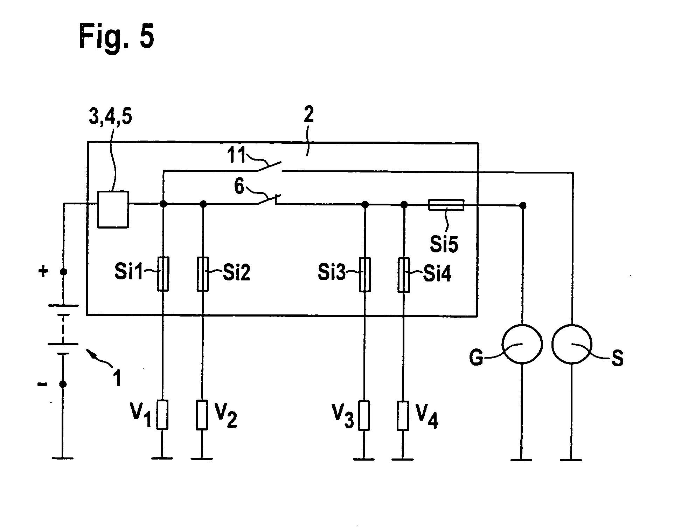

Die Figur 5 zeigt ein Blockschaltbild eines fünften Ausführungsbeispiels für die Erfindung. Das in der Figur 5 dargestellte Fahrzeugbordnetz unterscheidet sich von dem in der Figur 4 gezeigten Fahrzeugbordnetz dadurch, dass dem Starter S ein eigener Leistungsschalter 11 zugeordnet ist, der in das Modul 2 integriert ist. Der Generator G ist bei dem in der Figur 5 gezeigten Ausführungsbeispiel ebenso wie bei dem in Figur 4 gezeigten Ausführungsbeispiel über den Leistungsschalter 6 mit der Batterie verbunden, wobei jedoch zwischen dem Leistungsschalter 6 und dem Generator G eine weitere Sicherung Si5 vorgesehen ist. Diese ist ebenso wie der Leistungsschalter 6 Bestandteil des Moduls 2.

Mittels des Leistungsschalters 6 können Verbraucher - und Komponentengruppen auf oberster Bordnetzebene beispielsweise im Falle eines Unfalls zur Vermeidung eines Kabelbrands bei Kurzschluss oder zum Zwecke einer Ruhestromabschaltung im Fehler-, Transport- oder Servicefall abgeschaltet werden. Der Leistungsschalter 11 dient zum Schalten und Absichern der Starterleitung. Er kann beispielsweise das im Starter integrierte Hauptstromrelais ersetzen und somit die Starterleitung spannungsfrei schalten.

Eine Versorgung der Notverbraucher oder der Komponenten, die nicht von der Batterie getrennt werden dürfen, ist auch bei diesem Ausführungsbeispiel dadurch sichergestellt, dass diese Verbraucher zwischen der Batterie und dem Leistungsschalter 6 angeordnet sind, so dass sie auch bei geöffnetem Leistungsschalter 6 mit der Batterie 1 verbunden sind.

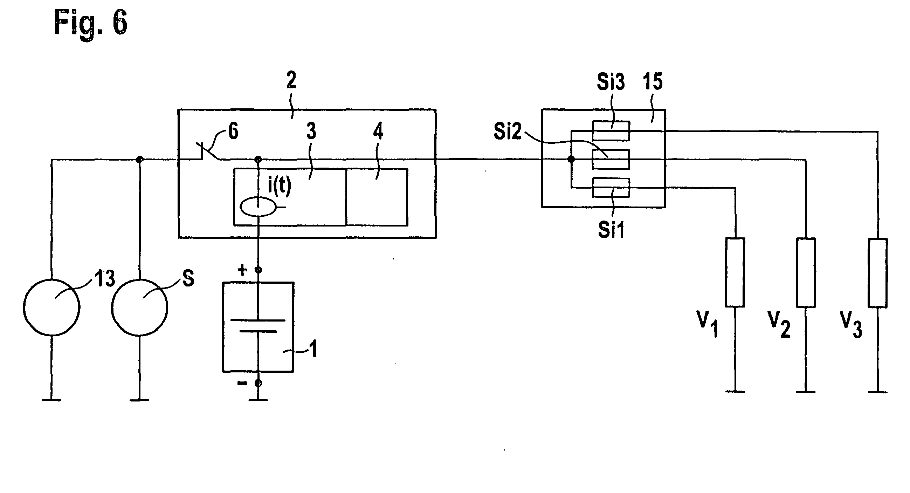

Die Figur 6 zeigt ein Blockschaltbild eines sechsten Ausführungsbeispiels für die Erfindung. Dieses Ausführungsbeispiel unterscheidet sich von den vorherigen Ausführungsbeispielen im wesentlichen dadurch, dass das Modul 2 nur einen einzigen Versorgungsausgang hat, an welchen eine Sicherungsbox 15 angeschlossen ist. In der Sicherungsbox 15 erfolgt eine Aufteilung der Hauptversorgungsleitung in drei Verbraucher-Versorgungsleitungen, wobei in jeder dieser Verbraucher-Versorgungsleitungen eine Sicherung Si1, Si2 bzw. Si3 angeordnet ist. Die Sicherungsbox 15 weist drei Versorgungsausgänge auf. An den ersten Versorgungsausgang ist ein Verbraucher V₁, an den zweiten Versorgungsausgang ein Verbraucher V₂ und an den dritten Versorgungsausgang ein Verbraucher V₃ angeschlossen.

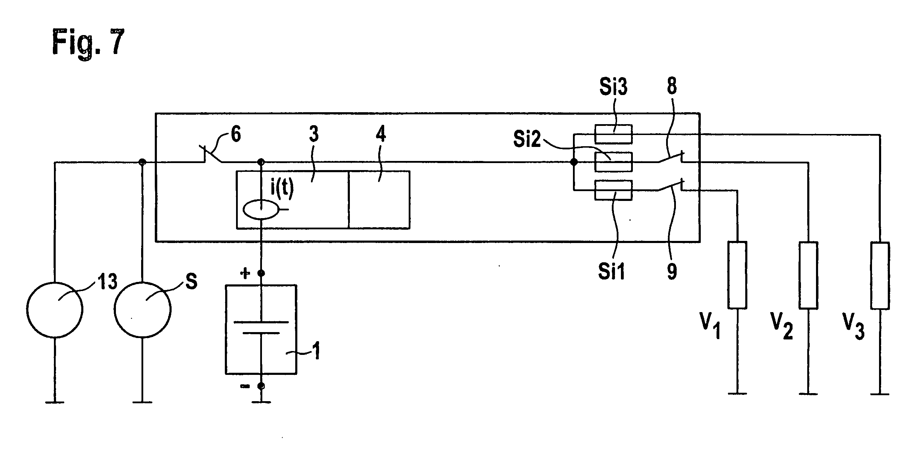

Die Figur 7 zeigt ein Blockschaltbild eines siebten Ausführungsbeispiels für die Erfindung. Dieses stimmt weitgehend mit dem in der Figur 1 gezeigten Ausführungsbeispiel überein und unterscheidet sich von diesem insbesondere dadurch, dass die Absicherung der Starter- und Generatorleitung ausschließlich über den Leistungsschalter 6 erfolgt und dass auf externe Sicherungsmaßnahmen verzichtet wird.

## Patentansprüche

1. Fahrzeugbordnetz, welches eine mit einem Pluspol und einem Minuspol versehene Batterie aufweist und welches zur Versorgung einer Vielzahl von Verbrauchern vorgesehen ist, wobei es ein zwischen dem Pluspol der Batterie (1) und den Verbrauchern (V₁, V₂, V₃) angeordnetes Modul (2) aufweist, welches Mittel zur Batteriezustandserkennung (3), eine Steuereinheit (4) zum Energiemanagement des Fahrzeugbordnetzes und mindestens einen Versorgungsausgang aufweist, über welchen die Verbraucher mit Energie versorgbar sind, wobei das Modul mehrere Versorgungsausgänge aufweist, wobei über diese Versorgungsausgänge jeweils ein Verbraucher mit Energie versorgbar ist und wobei zwischen diesen Versorgungsausgängen und der Batterie jeweils eine Sicherung vorgesehen ist, **dadurch gekennzeichnet, dass** zwischen mindestens einer der Sicherungen und dem zugehörigen Verbraucher ein innerhalb des Sicherungsmoduls oder Moduls vorgesehener Schalter vorgesehen ist, mittels welchem der jeweilige Verbraucher zu- und abschaltbar ist.

2. Fahrzeugbordnetz, welches eine mit einem Pluspol und einem Minuspol versehene Batterie aufweist und welches zur Versorgung einer Vielzahl von Verbrauchern vorgesehen ist, wobei es ein zwischen dem Pluspol der Batterie (1) und den Verbrauchern (V₁, V₂, V₃) angeordnetes Modul (2) aufweist, welches Mittel zur Batteriezustandserkennung (3), eine Steuereinheit (4) zum Energiemanagement des Fahrzeugbordnetzes und mindestens einen Versorgungsausgang aufweist, über welchen die Verbraucher mit Energie versorgbar sind, wobei das Modul (2) einen Anschluss aufweist, an welchen der Eingang eines Sicherungsmoduls (15) angeschlossen ist, wobei das Sicherungsmodul mehrere Versorgungsausgänge aufweist, wobei über jeden dieser Versorgungsausgänge ein Verbraucher mit Energie versorgbar ist, und wobei zwischen jedem der Versorgungsausgänge und dem Eingang eine Sicherung vorgesehen ist, **dadurch gekennzeichnet, dass** zwischen mindestens einer der Sicherungen und dem zugehörigen Verbraucher ein innerhalb des Sicherungsmoduls oder Moduls vorgesehener Schalter vorgesehen ist, mittels welchem der jeweilige Verbraucher zu- und abschaltbar ist.

3. Fahrzeugbordnetz nach Anspruch 1 oder 2, **dadurch gekennzeichnet, dass** die Mittel (3) zur Batteriezustandserkennung einen Batteriestrommesser enthalten.

4. Fahrzeugbordnetz nach einem der vorhergehenden Ansprüche, **dadurch gekennzeichnet, dass** die Mittel (3) zur Batteriezustandserkennung einen Batteriespannungsmesser enthalten, welcher mit einem außerhalb des Moduls angeordneten Batteriespannungssensor zusammenwirkt.

5. Fahrzeugbordnetz nach einem der vorhergehenden Ansprüche, **dadurch gekennzeichnet, dass** die Mittel (3) zur Batteriezustandserkennung einen Batterietemperaturmesser enthalten, welcher mit einem außerhalb des Moduls angeordneten Batterietemperatursensor zusammenwirkt.

6. Fahrzeugbordnetz nach einem der vorhergehenden Ansprüche, **dadurch gekennzeichnet, dass** das Modul einen Anschluss aufweist, an welchen ein Generator angeschlossen ist, und dass zwischen der Batterie und dem Anschluss innerhalb des Moduls ein Batterietrennschalter oder eine Sicherung angeordnet ist.

7. Fahrzeugbordnetz nach einem der vorhergehenden Ansprüche, **dadurch gekennzeichnet, dass** das Modul einen Anschluss aufweist, an welchen der Starter des Fahrzeugs angeschlossen ist, und dass zwischen der Batterie und dem Anschluss innerhalb des Moduls ein Relais angeordnet ist.

8. Fahrzeugbordnetz nach einem der vorhergehenden Ansprüche, **dadurch gekennzeichnet, dass** die Steuereinheit (4) zum Energiemanagement über eine Kommunikationsschnittstelle des Moduls mit mindestens einem Verbraucher des Fahrzeugbordnetzes und/oder mindestens einer weiteren Regel- oder Steuereinheit des Fahrzeugs kontaktiert ist.

9. Fahrzeugbordnetz nach Anspruch 8, **dadurch gekennzeichnet, dass** die Schnittstelle eine Bus-Schnittstelle ist.

10. Fahrzeugbordnetz nach Anspruch 8 oder 9, **dadurch gekennzeichnet, dass** das Modul (2) eine Elektronik (5) zur Regelung und Diagnose des Generators aufweist.

11. Fahrzeugbordnetz nach einem der vorhergehenden Ansprüche, **dadurch gekennzeichnet, dass** das Modul (2) Detektionsmittel aufweist, die zur Diagnose des Zustands mindestens einer der Sicherungen vorgesehen sind.

12. Fahrzeugbordnetz nach einem der vorhergehenden Ansprüche, **dadurch gekennzeichnet, dass** das Modul (2) mindestens einen Gleichspannungswandler (7) aufweist.

13. Fahrzeugbordnetz nach einem der vorhergehenden Ansprüche, **dadurch gekennzeichnet, dass** das Modul (2) mindestens einen Leistungsschalter (6) aufweist.

14. Fahrzeugbordnetz nach Anspruch 13, **dadurch gekennzeichnet, dass** der Leistungsschalter zur Zu- und Abschaltung einzelner Verbraucher oder einer Gruppe von Verbrauchern vorgesehen ist.

## Claims

1. Vehicle on-board power system which has a battery which is provided with a positive pole and a negative pole and which is provided for supplying a plurality of loads, wherein said vehicle on-board power system has a module (2) which is arranged between the positive pole of the battery (1) and the loads (V₁, V₂, V₃), which module (2) has means (3) for detecting the state of the battery, a control unit (4) for energy management of the vehicle on-board power system and at least one supply output by means of which the loads can be supplied with energy, wherein the module has a plurality of supply outputs, wherein in each case a load can be supplied with energy via these supply outputs, and wherein in each case a fuse is provided between these supply outputs and the battery, **characterized in that** a switch which is provided within the fuse module or module is provided between at least one of the fuses and the associated load, by means of which switch the respective load can be activated and deactivated.

2. Vehicle on-board power system which has a battery which is provided with a positive pole and a negative pole and which is provided for supplying a plurality of loads, wherein said vehicle on-board power system has a module (2) which is arranged between the positive pole of the battery (1) and the loads (V₁, V₂, V₃), which module (2) has means (3) for detecting the state of the battery, a control unit (4) for energy management of the vehicle on-board power system and at least one supply output by means of which the loads can be supplied with energy, wherein the module (2) has a terminal to which the input of a fuse module (15) is connected, wherein the fuse module has a plurality of supply outputs, wherein a load can be supplied with energy via each of these supply outputs, and wherein a fuse is provided between each of the supply outputs and the input, **characterized in that** a switch which is provided within the fuse module or module is provided between at least one of the fuses and the associated load, by means of which switch the respective load can be activated and deactivated.

3. The vehicle on-board power system according to Claim 1 or 2, **characterized in that** the means (3) for detecting the state of the battery contain a battery ammeter.

4. Vehicle on-board power system according to one of the preceding claims, **characterized in that** the means (3) for detecting the state of the battery contain a battery voltage meter which interacts with a battery voltage sensor which is arranged outside the module.

5. Vehicle on-board power system according to one of the preceding claims, **characterized in that** the means (3) for detecting the state of the battery contain a battery temperature meter which interacts with a battery temperature sensor which is arranged outside the module.

6. Vehicle on-board power system according to one of the preceding claims, **characterized in that** the module has a terminal to which a generator is connected, and **in that** a battery isolating switch or a fuse is arranged between the battery and the terminal within the module.

7. Vehicle on-board power system according to one of the preceding claims, **characterized in that** the module has a terminal to which the starter of the vehicle is connected and **in that** a relay is arranged between the battery and the terminal within the module.

8. Vehicle on-board power system according to one of the preceding claims, **characterized in that** the control unit (4) for performing energy management is placed in contact via a communications interface of the module with at least one load of the vehicle on-board power system and/or at least one further closed-loop or open-loop control unit of the vehicle.

9. Vehicle on-board power system according to Claim 8, **characterized in that** the interface is a bus interface.

10. Vehicle on-board power system according to Claim 8 or 9, **characterized in that** the module (2) has an electronic system (5) for performing closed-loop control and diagnosis of the generator.

11. Vehicle on-board power system according to one of the preceding claims, **characterized in that** the module (2) has detection means which are provided for diagnosing the state of at least one of the fuses.

12. Vehicle on-board power system according to one of the preceding claims, **characterized in that** the module (2) has at least one direct voltage transformer (7).

13. Vehicle on-board power system according to one of the preceding claims, **characterized in that** the module (2) has at least one power switch (6).

14. Vehicle on-board power system according to Claim 13, **characterized in that** the power switch is provided for activating and deactivating individual loads or a group of loads.

## Revendications

1. Réseau de bord pour véhicule, dans lequel :
une batterie dotée d'un pôle positif et d'un pôle négatif est prévue pour alimenter plusieurs consommateurs,
un module (2) est disposé entre le pôle positif de la batterie (1) et les consommateurs (V₁, V₂, V₃),
lequel module présentant des moyens de détection (3) de l'état de la batterie, une unité de commande (4) qui gère l'énergie du réseau de bord du véhicule et au moins une sortie d'alimentation par laquelle les consommateurs peuvent être alimentés en énergie,
le module présentant plusieurs sorties d'alimentation, chaque consommateur pouvant être alimenté en énergie par une de ces sorties d'alimentations et une protection étant prévue entre chacune de ces sorties d'alimentation et la batterie,
**caractérisé en ce que**
entre au moins l'une des protections et le consommateur associé, il présente à l'intérieur du module de protection ou du module un commutateur au moyen duquel chaque consommateur peut être branché et débranché.

2. Réseau de bord pour véhicule, dans lequel
une batterie dotée d'un pôle positif et d'un pôle négatif est prévue pour alimenter plusieurs consommateurs,
un module (2) est disposé entre le pôle positif de la batterie (1) et les consommateurs (V₁, V₂, V₃),
lequel module présentant des moyens de détection (3) de l'état de la batterie, une unité de commande (4) qui gère l'énergie du réseau de bord du véhicule et au moins une sortie d'alimentation par laquelle les consommateurs peuvent être alimentés en énergie,
le module (2) présentant une borne de raccordement à laquelle l'entrée d'un module de protection (15) est raccordée,
le module de protection présentant plusieurs sorties d'alimentation, chaque consommateur pouvant être alimenté en énergie par une de ces sorties d'alimentation, une protection étant prévue entre chacune des sorties d'alimentation et l'entrée,
**caractérisé en ce que**
entre au moins l'une des protections et le consommateur associé, il présente à l'intérieur du module de protection ou du module un commutateur au moyen duquel chaque consommateur peut être branché et débranché.

3. Réseau de bord pour véhicule selon les revendications 1 ou 2, **caractérisé en ce que** les moyens (3) de détection de l'état de la batterie contiennent un dispositif de mesure du courant de batterie.

4. Réseau de bord pour véhicule selon l'une des revendications précédentes, **caractérisé en ce que** les moyens (3) de détection de l'état de la batterie contiennent un dispositif de mesure de la tension de batterie qui coopère avec une sonde de tension de batterie disposée à l'extérieur du module.

5. Réseau de bord pour véhicule selon l'une des revendications précédentes, **caractérisé en ce que** les moyens (3) de détection de l'état de la batterie contiennent un dispositif de mesure de température de la batterie qui coopère avec une sonde de température de batterie disposée à l'extérieur du module.

6. Réseau de bord pour véhicule selon l'une des revendications précédentes, **caractérisé en ce que** le module présente une borne de raccordement à laquelle est raccordé un générateur et **en ce qu'**un commutateur de séparation de batterie ou une protection sont disposés à l'intérieur du module entre la batterie et la borne de raccordement.

7. Réseau de bord pour véhicule selon l'une des revendications précédentes, **caractérisé en ce que** le module présente une borne de raccordement à laquelle est raccordé le démarreur du véhicule et **en ce qu'**un relais est disposé à l'intérieur du module entre la batterie et la borne de raccordement.

8. Réseau de bord pour véhicule selon l'une des revendications précédentes, **caractérisé en ce que** pour la gestion de l'énergie, l'unité de commande (4) est mise en contact par une interface de communication du module avec au moins un consommateur du réseau de bord du véhicule et/ou au moins une autre unité de régulation ou de commande du véhicule.

9. Réseau de bord pour véhicule selon la revendication 8, **caractérisé en ce que** l'interface est une interface de bus.

10. Réseau de bord pour véhicule selon les revendications 8 ou 9, **caractérisé en ce que** le module (2) présente une électronique (5) de régulation et de diagnostic du générateur.

11. Réseau de bord pour véhicule selon l'une des revendications précédentes, **caractérisé en ce que** le module (2) présente des moyens de détection qui sont prévus pour diagnostiquer l'état d'au moins l'une des protections.

12. Réseau de bord pour véhicule selon l'une des revendications précédentes, **caractérisé en ce que** le module (2) présente au moins un convertisseur (7) de tension continue.

13. Réseau de bord pour véhicule selon l'une des revendications précédentes, **caractérisé en ce que** le module (2) présente au moins un commutateur de puissance (6).

14. Réseau de bord pour véhicule selon la revendication 13, **caractérisé en ce que** le commutateur de puissance est prévu pour brancher et débrancher différents consommateurs ou un groupe de consommateurs.
